# EUROPEAN PATENT APPLICATION

(11) **EP 2 473 015 A2**
(43) Date of publication of application: **04.07.2012**
(21) Application number: 11275163.1
(22) Date of filing: 20.12.2011
(51) Int. Cl.: H05K 3/12, H05K 1/09

(54) **Method for forming wiring and electrode using metal nano paste**

(30) Priority: 29.12.2010 KR 20100138273
(71) Applicant: Samsung Electro-Mechanics Co., Ltd, Suwon, Gyunggi-Do (KR)
(72) Inventor: Jang, Seon Hee, 331-826 Chungcheongnam-do (KR); Lee, Young II, 431-757 Gyeonggi-do (KR); Kim, Dong Hoon, 463-730 Gyeonggi-do (KR); Kim, Sung Eun, 443-740 Gyeonggi-do (KR); Cho, Hye Jin, 151-712 Seoul (KR)
(74) Representative: Powell, Timothy John

(57) **Abstract**

Disclosed herein is a method for forming a metal wiring and an electrode using a metal nano paste, including a sintering process, wherein the sintering includes: placing a substrate on which a metal nano paste is printed in a furnace and raising a temperature of the furnace to 220 to 240 Celsius under a nitrogen atmosphere; heating the substrate under a mixed atmosphere of carboxylic acid and air while the temperature of the furnace is maintained at the temperature range; dropping the temperature of the furnace to 100 to 150 Celsius under the mixed atmosphere of carboxylic acid and air; and dropping the temperature of the furnace to room temperature under a nitrogen atmosphere. According to the present invention, a metal film having high density and a mimimized amount of residual metal particles can be formed despite a low-temperature sintering process, like a case where a high-temperature sintering process is employed.

## Description

### CROSS REFERENCE(S) TO RELATED APPLICATIONS

This application claims the benefit under 35 U.S.C. Section 119 of Korean Patent Application Serial No. 10-2010-0138273, entitled "Method for Forming Wiring and Electrode Using Metal Nano Paste" filed on December 29, 2010, which is hereby incorporated by reference in its entirety into this application.

### BACKGROUND OF THE INVENTION

### 1. Technical Field

The present invention relates to a method for forming a meal wiring or an electrode, including sintering a wiring or an electrode printed with a metal nano paste through a specific manner.

### 2. Description of the Related Art

A printed circuit board is an electronic part in which various devices can be mounted and devices can be electrically connected, through integration of wirings, and it is widely used in semiconductors, solar cells, multimedia equipment, telecommunications equipment, consumer electronics, vehicles, and the like.

In order to form circuits for this circuit board, a normal organic composition is generally poured into a screen mesh having a pattern carved thereon so that only regions where wirings are to be formed are printed, and a paste containing metal such as silver, copper, or the like is applied thereon by using inkjet printing, screen printing, or the like, followed by a sintering process.

The sintering process is defined by a heat treatment for solid - phase structuring through material transfer occurring at an atomic level by binding metal particles in a self-alignment manner. When a wiring or electrode type of metal nano paste is subjected to the sintering process, a binder is removed and metal particles fuse and grow, so that a metal film having electric properties close to a bulky metal is formed.

As slimness and diversification of a substrate on which wirings and electrodes using nanoparticles are formed has recently advanced, the sintering process is requested to be performed at a low temperature. In this situation, there may be a method of performing the sintering process at a low temperature by changing the composition or the like of the metal nano paste. However, the method requires much development costs since properties of respective metals need to be considered, and may have adverse effects on other physical and chemical properties of metal wirings and electrodes.

Therefore, it is urgent to develop methods, according to which, the sintering process is performed at a low temperature of 250 Celsius or lower while density of the metal film is improved to achieve electric properties needed for the metal wirings and electrodes.

### SUMMARY OF THE INVENTION

An object of the present invention is to provide a method for forming a metal wiring and an electrode capable of exhibiting excellent electric properties close to a bulky metal even through a sintering process at a low temperature of below 250 Celsius.

Another object of the present invention is to provide a method for forming a metal wiring and an electrode having excellent electric properties in a simple manner by property regulating a sintering atmosphere for a sintering process.

According to one exemplary embodiment of the present invention, there is provided a method for forming a metal wiring or an electrode, including a sintering process, wherein the sintering includes: placing a substrate on which a metal nano paste is printed in a furnace and raising a temperature of the furnace to 220 to 240 Celsius under a nitrogen atmosphere; heating the substrate under a mixed atmosphere of carboxylic acid and air while the temperature of the furnace is maintained at the temperature range; dropping the temperature of the furnace to 100 to 150 Celsius under the mixed atmosphere of carboxylic acid and air; and dropping the temperature of the furnace to room temperature under a nitrogen atmosphere.

The mixed atmosphere may consist of 40 to 60vol% of carboxylic acid and 60 to 40vol% of air.

The nitrogen atmosphere may consist of a forming gas containing hydrogen gas of below 10vol% and the balance nitrogen gas.

The metal nano paste may contain at least one metal selected from the group consisting of silver (Ag), copper (Cu), nickel (Ni), gold (Au), platinum (Pt), palladium (Pd), lead (Pb), indium (In), rhodium (Rh), ruthenium (Rd), iridium (Ir), osmium (Os), tungsten (W), tantalum (Ta), bismuth (Bi), tin (Sn), zinc (Zn), titanium (Ti), aluminum (Al), cobalt (Co) and iron (Fe).

The carboxylic acid may be formic acid, acetic acid, or propionic acid.

### BRIEF DESCRIPTION OF the DRAWINGS

FIG. 1 is a schematized graph of a sintering process according to Example of the present invention (F/A means formic acid in FIG. 1);
FIG. 2 is a schematized graph of a sintering process of Comparative Example 1;
FIG. 3 is a schematized graph of a sintering process of Comparative Example 2; and
FIG. 4 is a schematized graph of a sintering process of Comparative Example 3.

### DESCRIPTION OF THE PREFERRED EMBODIMENTS

The present invention is directed to a method for forming a metal wiring and an electrode using a metal nano paste, including a sintering process, wherein the sintering includes: placing a substrate on which a metal nano paste is printed in a furnace and raising a temperature of the furnace to 220 to 240 Celsius under a nitrogen atmosphere; heating the substrate under a mixed atmosphere of carboxylic acid and air while the temperature of the furnace is maintained at the temperature range; dropping the temperature of the furnace to 100 to 150 Celsius under the mixed atmosphere of carboxylic acid and air; and dropping the temperature of the furnace to room temperature under a nitrogen atmosphere. According to the present invention, a metal film having high density and a mimimized amount of residual metal particles can be formed despite a low-temperature sintering process, like a case where a high-temperature sintering process is employed.

Hereinafter, the present invention will be described in more detail.

A sintering process of the present invention is largely divided into four steps.

As a first step, a substrate on which a metal nano paste is printed is placed in a furnace, and a temperature of the furnace is gently raised to 220 to 240 Celsius under a nitrogen atmosphere. As such, a temperature raising process needs to be performed under a nitrogen atmosphere so as to prevent cracks from being generated in the metal wiring and electrode. Further, the temperature needs to be gently raised so as to prevent an undesired reaction between metal and organic materials, such as a binder contained in the paste, a solvent, and the like.

The substrate is not particularly limited to specific kinds, and examples thereof may include a silicon substrate, a flexible substrate, or the like. For example, the substrate according to the present invention may include a silicon substrate that is textured so as to increase energy efficiency as a substrate for a solar cell and has an anti-reflection film of SiNx, SiO₂, TiO₂, or the like. Further, the substrate according to the present invention may include all substrates that can be used in electronic devices such as semiconductors, displays, cellular phones, and the like.

The metal nano paste is not limited to a paste having a particular composition. A metal nano paste having a normal composition may be used in order to form the electrode and the wiring, and examples thereof may include at least one metal selected from the group consisting of silver (Ag), copper (Cu), nickel (Ni), gold (Au), platinum (Pt), palladium (Pd), lead (Pb), indium (In), rhodium (Rh), ruthenium (Rd), iridium (Ir), osmium (Os), tungsten (W), tantalum (Ta), bismuth (Bi), tin (Sn), zinc (Zn), titanium (Ti), aluminum (Al), cobalt (Co) and iron (Fe). Metal nanoparticles may have an average particle size of about 3 to 10µm.

The metal nano paste is a material that is printed on the substrate. Examples of the printing method may include inkjet printing, screen printing, and the like.

In the first step, for example, in a case where a silver nano paste is used, it may take about 60 minutes to raise the temperature of the furnace from room temperature to 220 to 240 Celsius. The time for raising temperature may depend on the size and pressure of the furnace, and may depend on the kind of metal.

In the first step, the nitrogen atmosphere may include 100vol% of nitrogen, or a forming gas where nitrogen gas takes a major part and the balance hydrogen gas of below 10vol%.

As a second step, the substrate is heated under a mixed atmosphere of carboxylic acid and air while the temperature of the furnace is maintained at a temperature range described in the first step. The carboxylic acid is effective in removing organic materials contained in a conductive paste, with the result that density of a metal film can be effectively improved, thereby lowering specific resistivity values of the wiring and the electrode.

In the second step, the temperature of the furnace is maintained within the range of 220 to 240 Celsius, and preferably 225 to 235 Celsius. The sintering process of the present invention has an advantage in that the sintering process need not be performed at a high temperature of 250 Celsius or higher. The electrode and the wiring having a specific resistivity close to a specific resistivity value of a bulky metal by performing sintering even within the range of 220-240 Celsius.

In the second step, a mixture gas of carboxylic acid and air may consist of 40 to 60vol% of carboxylic acid and 60 to 40vol% of air. A content ratio of the mixture gas may sightly depend on the kinds of organic materials contained in the metal nano paste.

The carboxylic acid is a compound containing a carboxylic acid (-COOH), and examples thereof may include formic acid, acetic acid, propionic acid, and the like.

In the heating of the second step, it may take about 60 minutes to raise the temperature to 220 to 240 Celsius, and preferably 225 to 235 Celsius, in a case where a silver nano paste is used. The time for heating may depend on the size and pressure of the furnace, and may depend on the kind of metal. For example, the time for heating may be 1 to 2 hours.

As a third step, the temperature of the furnace is dropped to 100 to 150 Celsius under the mixed atmosphere of carboxylic acid and air. This step enables the sintering procedure to be maintained and the temperature of the furnace to be dropped.

In the third step, the mixed atmosphere of carboxylic acid and air of the second step is maintained, so as contribute to improve density of the metal film and prevent oxidation of the metal film caused by inputting atmospheric oxygen into the metal film when nitrogen gas is inputted (in a fourth step) directly after the temperature of the furnace is dropped.

In the third step, the temperature range of the furnace ranges from 100 to 150 Celsius. If the temperature of the furnace is dropped below this temperature range, unnecessary sintering may proceed. The time for dropping the temperature may depend on the size and pressure of the furnace, and may depend on the kind of metal.

As a fourth step, the temperature of the furnace is dropped to room temperature under a nitrogen atmosphere. In the fourth step, a nitrogen atmosphere needs to be formed since unnecessary sintering may proceed in a case where the mixed atmosphere of carboxylic acid and air is continuously introduced at room temperature. The wiring and electrode is gently cooled under the nitrogen atmosphere, so that the metal film is not oxidized.

The room temperature means 25 to 30 Celsius.

In the fourth step, the nitrogen atmosphere may include 100vo1% of nitrogen, or a forming gas where nitrogen gas takes a major part and the balance hydrogen gas of below 10vol%, like the first step.

Through the above sintering process including four steps, a particle size becomes large and a pore size becomes small within the metal film, with the result that density of the metal film is improved, thereby forming a wiring and an electrode having excellent electric properties.

Hereinafter, preferred embodiments are described in order to help the understanding of the present invention. The following embodiments describe the present invention by way of example only, but not limit the scopes of the accompanying claims. It is apparent to those skilled in the art that various changes and modifications can be made in the scope and spirit of the present invention. It is to be understood that the present invention is intended to cover these changes and modifications included in the appended claims.

### Examples

### Example 1

A wiring was printed on a silicon substrate for a solar cell including an antireflection film by using a silver nano paste through screen printing. The resultant substrate was placed in a furnace and then a sintering process was performed thereon. Formic acid was used as carboxylic acid to be used in a sintering atmosphere.

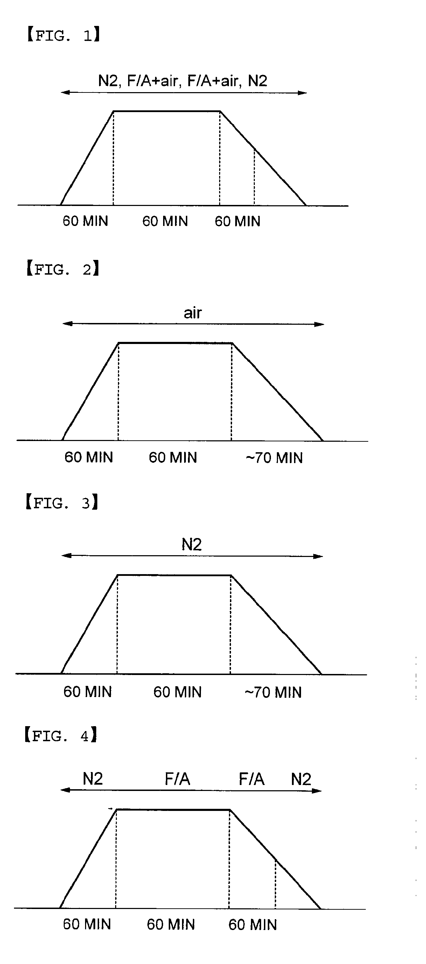

The temperature for heating in the second step was set to 230 Celsius and sintering was performed in a temperature rise section for 1 hour. The pressure of the furnace was maintained at an atmospheric pressure. A specific sintering profile is shown in FIG. 1.

### Comparative Example 1

A sintering process was performed in the same manner as Example 1 except that a sintering atmosphere is constituted by using air throughout the sintering process. A sintering profile of Comparative Example 1 is shown in FIG. 2.

### Comparative Example 2

A sintering process was performed in the same manner as Comparative Example 1 except that a sintering atmosphere is constituted by using nitrogen throughout the sintering process. A sintering profile of Comparative Example 2 is shown in FIG. 3.

### Comparative Example 3

A sintering process was performed in the same manner as Example 1 except that a sintering atmosphere is constituted by using nitrogen during a first step, formic acid during a second step, formic acid during a third step, and nitrogen during a fourth step. A sintering profile of Comparative Example 3 is shown in FIG. 4.

### Experimental Example

Properties of a metal wiring subjected to sintering processes of Example 1 and Comparative Examples 1 to 3 were measured, and the results were tabulated in Table 1. It can be seen that a specific resistivity value in Example 1 is excellent, considering a specific resistivity value of bulky Ag, 1.59 uohm-cm. Comparative Examples 1 to 3 were significantly larger than that Example 1 in view of specific resistivity value.

**[Table 1]**

| Average value | Example 1 | Comparative Example 1 | Comparative Example 2 | Comparative Example 3 |
|---|---|---|---|---|
| R (Resistance, ohm) | 1.33 | 1.7 | 4-5 Mohm | 2.97 |
| W (width, µm) | 297 | 309 | 302 | 296 |
| T (thickness, µm) | 3.6 | 3.57 | 5.2 | 4.47 |
| L (length, cm) | 4.0 | 4.0 | 4.0 | 4.0 |
| resistivity (micro ohm-cm) | 3.47 | 4.69 | Very large | 9.82 |

According to the result obtained by the sintering process of Comparative Example 1, particles were grown, and pores due to sintering shrinkage existed in fine structures of a bottom face/a cross section, but residual metal particles were not shown, and thus, a low resistance value could be exhibited.

According to the result obtained by the sintering process of Comparative Example 2, necking between particles occurred, which was further developed to form coalescence of particles. However, organic materials were not completely removed, judging from the fact that a film was badly released at the time of tape testing, and sintering was not sufficiently completed, judging from a fine structure of a cross section. For these reasons, a significantly large resistance value of 4-5Mohm was exhibited at the time of 2-point resistance measurement.

According to the result obtained by the sintering process of Comparative Example 3, particles were grown. However, it could be seen that sintering was not sufficiently completed because non-sintered metal particles were shown in a surface/a bottom face and metal particles per se were shown in a cross section structure.

Whereas, according to the result obtained by the sintering process of Example 1, an excellent film where particles are largely grown to several um as compared with Comparative Examples 1 to 3 can be obtained. Despite a bottom face of the film is not clearly separated from the substrate at the time of sampling, a fine structure of the bottom face was not significantly different from a fine structure of a surface, and un-sintered metal particles were not shown. A densified metal film together with growth of particles was obtained, and thus, a specific resistivity value thereof was 3.47 uohm-cm, which was the smallest value as compared with Comparative Examples 1 to 3.

According to the method for forming a metal wiring and an electrode including a sintering process, even by a low-temperature sintering process of below 250 Celsius, a metal wiring or an electrode exhibiting electric properties close to those of a metal wiring or an electrode formed by performing a high-temperature sintering process can be obtained.

The method for forming a metal wiring and an electrode can be usefully applied to a case of using a substrate on which high-temperature sintering is not performed, or a case of using a thin film type substrate.

According to the present invention, through a simple method of controlling only sintering conditions while utilizing an ordinary metal nano paste, density of the metal film can be improved and the amount of residual metal particles can be minimized, and thus, a metal wire or an electrode exhibiting an excellent specific resistivity value close to a specific resistivity value of a bulky metal can be formed.

While the present invention has been shown and described in connection with the embodiments, it will be apparent to those skilled in the art that modifications and variations can be made without departing from the spirit and scope of the invention as defined by the appended claims.

## Claims

1. A method for forming a metal wiring or an electrode, comprising a sintering process, wherein the sintering includes:
placing a substrate on which a metal nano paste is printed in a furnace and raising a temperature of the furnace to 220 to 240 Celsius under a nitrogen atmosphere;
heating the substrate under a mixed atmosphere of carboxylic acid and air while the temperature of the furnace is maintained at the temperature range;
dropping the temperature of the furnace to 100 to 150 Celsius under the mixed atmosphere of carboxylic acid and air; and
dropping the temperature of the furnace to room temperature under a nitrogen atmosphere.

2. The method according to claim 1, wherein the mixed atmosphere consists of 40 to 60vol% of carboxylic acid and 60 to 40vol% of air.

3. The method according to claim 1, wherein the nitrogen atmosphere consists of a forming gas containing hydrogen gas of below 10vol% and the balance nitrogen gas.

4. The method according to claim 1, wherein the metal nano paste contains at least one metal selected from the group consisting of silver (Ag), copper (Cu), nickel (Ni), gold (Au), platinum (Pt), palladium (Pd), lead (Pb), indium (In), rhodium (Rh), ruthenium (Rd), iridium (Ir), osmium (Os), tungsten (W), tantalum (Ta), bismuth (Bi), tin (Sn), zinc (Zn), titanium (Ti), aluminum (Al), cobalt (Co) and iron (Fe).

5. The method according to claim 1, wherein the carboxylic acid is formic acid, acetic acid, or propionic acid.
